# FASCICULE DE BREVET EUROPEEN

(11) **EP 1 042 682 B1**
(45) Date de publication et mention de la délivrance du brevet: **12.06.2002**
(21) Numéro de dépôt: 98963609.7
(22) Date de dépôt: 23.12.1998
(51) Int. Cl.: G01R 31/28, G01N 27/403

(54) **DISPOSITIF ET PROCEDE DE TEST D'ELEMENTS SENSIBLES D'UNE PUCE ELECTRONIQUE**
VERFAHREN UND ANORDNUNG ZUR PRÜFUNG DER EMPFINDLICHEN ELEMENTE EINES HALBLEITERCHIPS
DEVICE AND METHOD FOR TESTING AN ELECTRONIC CHIP SENSITIVE ELEMENT

(30) Priorité: 24.12.1997 FR 9716516
(43) Date de publication de la demande: 11.10.2000
(73) Titulaire: COMMISSARIAT A L'ENERGIE ATOMIQUE, 75015 Paris (FR)
(72) Inventeur: LIVACHE, Thierry, F-38000 Grenoble (FR); CAILLAT, Patrice, F-38130 Echirolles (FR)
(74) Mandataire: Weber, Etienne Nicolas
(86) Numéro de dépôt international: FR9802849
(87) Numéro de publication internationale: WO9934227

(56) Documents cités:
- EP-A- 0 400 387
- WO-A-81/00646
- US-A- 4 743 954

## Description

### Domaine technique

La présente invention concerne un dispositif et un procédé de test d'éléments sensibles à la surface d'une puce électronique.

De plus en plus des puces électroniques sont utilisées en tant que support d'analyse et/ou de capteur d'information dans les domaines de l'analyse biologique ou chimique, ou pour la mesure de grandeurs physiques. Les puces électroniques comportent à cet effet à leur surface une pluralité de capteurs, de récepteurs ou de microsystèmes désignés ci-après par "éléments sensibles". Les éléments sensibles sont, par exemple, des électrodes pouvant être plongées dans un fluide à analyser. Ces électrodes sont alors sélectivement recouvertes d'une couche de garniture sensible à un composé chimique ou biologique donné. Dans certains cas, les puces peuvent également comporter des moyens pour adresser sélectivement les éléments sensibles afin d'y appliquer un potentiel électrique ou pour effectuer des mesures électriques individuelles sur ces éléments.

La présente invention trouve des applications en particulier dans le contrôle du bon fonctionnement de puces électroniques équipées d'électrodes et dans le contrôle de la qualité des couches de garniture sensible qui recouvrent les électrodes.

### Etat de la technique antérieure

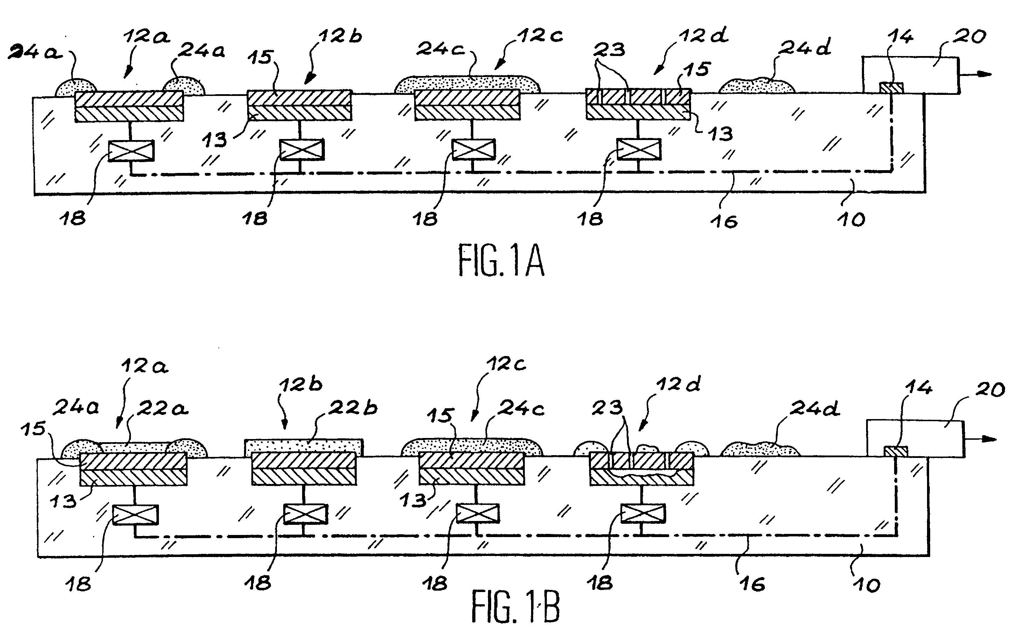

La figure 1A annexée est une coupe schématique d'une puce électronique comportant des électrodes.

La puce comporte un substrat 10 avec une pluralité d'électrodes. Pour des raisons de clarté seules quatre électrodes sont représentées sur la figure, ces électrodes portent respectivement les références 12a, 12b, 12c et 12d. Une puce peut cependant comporter un grand nombre d'électrodes. Les électrodes comportent une couche inférieure 13 en un matériau tel que le titane, par exemple, recouverte par une couche supérieure 15 en un métal tel que l'or, ou le platine.

Afin de conférer aux électrodes leur fonction de capteur biologique ou chimique, celles-ci sont garnies d'une couche en un matériau réactif ou un matériau susceptible d'interagir avec de la matière biologique. Ces matériaux peuvent comporter des polymères conducteurs électriques. A titre d'exemple un polypyrrole modifié peut être utilisé comme couche biologiquement sensible.

Toutes les électrodes peuvent être recouvertes du même matériau ou peuvent être sélectivement recouvertes de différents matériaux sensibles à différents composés. A titre d'illustration de l'utilisation de puces équipées d'électrodes, pour l'analyse de produits chimiques ou biologiques, on peut se reporter, par exemple, aux documents (1) et (2) dont les références sont indiquées à la fin de la présente description. Le document (3), également référencé, concerne plus généralement l'usinage du silicium et la fabrication de capteurs.

Par retour à la figure 1A, on observe que les électrodes 12 de la puce 10 sont électriquement reliées à des bornes d'entrée-sortie 14 dont une seule est représentée. La liaison électrique est schématisée par un trait mixte 16.

Dans le cas où la puce comporte un nombre réduit d'électrodes, chaque électrode peut être respectivement connectée à une borne d'entrée-sortie particulière qui lui est associée.

Cependant, comme le montre la figure 1A, la liaison entre les électrodes et les bornes d'entrée-sortie peut aussi avoir lieu par l'intermédiaire de circuits multiplexeurs 18.

Les circuits multiplexeurs permettent d'adresser à partir d'un nombre réduit de bornes d'entrée-sortie jusqu'à plusieurs centaines d'électrodes à la surface de la puce.

Au sens de la présente description on entend par adressage, la mise en liaison électrique d'au moins une électrode (ou autre élément sensible) avec au moins une borne d'entrée-sortie. L'adressage d'une électrode permet non seulement d'y appliquer une tension ou un signal par l'intermédiaire d'une ou plusieurs bornes d'entrée-sortie mais aussi d'effectuer des mesures électriques sur cette électrode.

Pour effectuer l'adressage, c'est-à-dire pour sélectionner un certain nombre d'électrodes, les bornes d'entrée-sortie sont reliées à des dispositifs électroniques de contrôle extérieurs, non représentés, par exemple, par des moyens de connexion 20, représentés sommairement.

Sur la figure 1A, on observe que la couche de métal supérieure 15 de l'électrode 12d présente une porosité 23 susceptible de laisser un fluide venir en contact avec la couche inférieure 13 sous-jacente de l'électrode.

Par ailleurs, lors de la fabrication des électrodes, des résidus de matériau peuvent rester à la surface de la puce. Il s'agit, par exemple, de résidus de vernis mis en oeuvre lors d'opérations de formation de masques de gravure.

De tels résidus repérés sur la figure 1A avec les références 24a, 24c et 24d peuvent recouvrir en partie une électrode, ce qui est le cas de l'électrode 12a, la recouvrir totalement, ce qui est le cas de l'électrode 12c, ou subsister dans une région dépourvue d'électrodes, ce qui est le cas du résidu 24d.

Comme évoqué précédemment, les électrodes d'une puce, destinée à l'analyse de milieux biologiques ou chimiques, sont recouvertes d'une couche de matériau qui leur confère leur sensibilité à un composé chimique ou un produit biologique donné.

Le garnissage des électrodes de la puce de la figure 1A est illustré par la figure 1B. On observe que l'électrode 12b de la figure 1B est recouverte d'une couche sensible 22b, par exemple de polymère conducteur. La couche sensible 22b recouvre l'ensemble de la surface de l'électrode. La couche sensible peut être formée par des procédés de dépôt sélectif ou éventuellement par voie électrochimique en appliquant sélectivement à chaque électrode devant être garnie un courant d'électrolyse approprié.

On observe, par contre, pour l'électrode 12a, que le matériau de la couche sensible 22a ne recouvre qu'une partie de sa surface non encombrée par le résidu 24a. Ainsi, le recouvrement de l'électrode 12a n'est pas homogène,

Pour l'électrode 12c, on observe que le résidu 24c qui recouvre l'ensemble de la surface empêche la formation d'une couche sensible.

Il apparaît enfin que l'électrode 12d de la figure 1B a été en partie détruite lors de l'étape de garnissage.

La couche inférieure 13 de cette électrode, en n'étant pas correctement protégée par la couche supérieure 15, en raison de la porosité 23, a subi une altération provoquée par les agents ou fluides mis en oeuvre pour la garniture des électrodes. Ainsi, l'électrode 12d est impropre à effectuer des mesures d'analyse.

Des électrodes telles que l'électrode 12a ou 12c qui sont soit dépourvues de couche sensible, soit sont équipées d'une couche ne recouvrant que partiellement leur surface, conduisent à des résultats d'analyse erronés.

Par ailleurs, un résidu tel que le résidu 24d, visible sur les figures 1A et 1B, même s'il ne perturbe pas directement la formation d'une couche sensible, risque d'interférer avec les mesures d'analyse effectuées sur les électrodes voisines.

L'ensemble des défauts probables évoqués ci-dessus est susceptible d'interdire le fonctionnement ou de perturber le fonctionnement d'un certain nombre d'électrodes d'analyse d'une puce.

Des problèmes similaires se posent aussi pour les puces équipées d'autres éléments sensibles tels que des éléments de micromécanique, dont le fonctionnement peut également être perturbé par des résidus de matériau ou par des défauts engendrés lors des procédés de fabrication.

Dans le domaine de la micro-électronique, on connaît un certain nombre de tests prévus pour contrôler le bon fonctionnement de puces électroniques.

Parmi ces tests on distingue notamment les tests de conductimétrie et les tests visuels.

Les tests de conductimétrie, consistent pour l'essentiel à déplacer des pointes conductrices mobiles à la surface d'une puce afin de les mettre en contact avec des éléments conducteurs de cette puce et vérifier le passage d'un courant de mesure.

Cependant, dans une application à des puces d'analyse, les tests électriques à pointes mobiles ne permettent pas de détecter les électrodes qui sont certes recouvertes d'une couche de garniture, mais pour lesquelles la couche de garniture présente des inhomogénéités ou des porosités, ou ne recouvre qu'une partie de l'électrode, comme dans le cas de l'électrode 12a de la figure 1B.

De plus, les tests électriques à pointes mobiles présentent une résolution qui rend difficile leur mise en oeuvre pour des puces dont le pas des électrodes est inférieur à 50 µm.

En outre, les pointes de test mobiles déplacées à la surface de la puce risquent de briser localement une couche de résidu recouvrant une électrode et venir localement en contact avec l'électrode sous-jacente. Dans ce cas, un courant de mesure peut être détecté et l'électrode est considérée comme fonctionnelle alors qu'elle reste pour l'essentiel recouverte par la couche de résidu. Ainsi, une électrode telle que l'électrode 12c de la figure 1 serait considérée à tort comme valide.

De la même façon, le déplacement des pointes de test mobiles à la surface d'une puce risque de détériorer mécaniquement la couche de revêtement des électrodes. Le test est alors destructif.

Enfin, il convient d'ajouter que les tests électriques des puces par des pointes mobiles s'avèrent trop longs et donc inadaptés pour le contrôle des puces comportant de nombreuses électrodes.

Les tests visuels, effectués par microscopie, ne sont valables que lorsque les couches de revêtement à contrôler présentent une certaine épaisseur. Lorsque la couche de revêtement des électrodes est formée par un dépôt très fin, telle qu'une couche monomoléculaire ou une couche formée par adsorption de matière sur les électrodes, les méthodes de test visuel s'avèrent insatisfaisantes et inadaptées. Ceci est le cas notamment pour des puces comportant des électrodes d'analyse.

Finalement, les tests connus et usuels dans le domaine de la micro-électronique s'avèrent inadaptés pour le contrôle de puces d'analyse telles que décrites précédemment. En particulier, ces tests ne permettent pas d'évaluer correctement, de façon qualitative et quantitative, le fonctionnement des électrodes.

### Exposé de l'invention

La présente invention a pour but de proposer un procédé de test permettant de vérifier le bon fonctionnement d'une puce comportant des éléments sensibles, par un contrôle qualitatif et quantitatif du fonctionnement de chaque élément sensible de la puce.

Un autre but est de proposer un procédé de test ne présentant pas les difficultés ou limitations indiquées ci-dessus.

Un but est en particulier de proposer un tel procédé susceptible d'être appliqué de manière systématique à des puces comportant des électrodes adressables.

Un but est encore de proposer un tel procédé, pouvant être mis en oeuvre avant ou après la formation de revêtements fonctionnels sur les électrodes et qui permette non seulement le contrôle du système d'adressage des électrodes, mais également, le cas échéant, la qualité et l'homogénéité des couches de revêtement de celles-ci.

Un autre but de l'invention est de proposer un procédé de test peu coûteux et non destructif permettant de tester automatiquement et individuellement, si nécessaire, tous les éléments sensibles.

Un but de l'invention est également de proposer un dispositif de test simple et peu coûteux destiné à mettre en oeuvre le procédé de test.

Pour atteindre ces buts, l'invention a plus précisément pour objet un procédé de test d'une puce électronique comportant en surface une pluralité d'éléments sensibles conducteurs adressables, dans lequel on met en contact les éléments sensibles de la puce avec une solution conductrice, dans lequel on adresse sélectivement un ou plusieurs éléments sensibles pour appliquer à chaque élément sensible adressé un signal électrique de test dit signal d'entrée, et on mesure un signal, dit signal de sortie, par exemple sur une contre-électrode en contact avec la solution conductrice.

La solution conductrice est, par exemple, une solution aqueuse ou organique suffisamment conductrice pour laisser passer un courant mesurable, et la moins agressive possible vis-à-vis du substrat à tester, aussi bien durant l'activation électrochimique qu'au repos. On peut utiliser, par exemple, de l'eau ou un mélange de solvants additionné éventuellement d'éléments tels que des sels, diminuant sa résistance électrique.

Avantageusement, la solution conductrice peut être un liquide identique ou similaire à un liquide devant être ultérieurement analysé ou utilisé pour l'analyse.

Grâce au procédé de l'invention, aucun contact mécanique avec la puce n'est nécessaire, ainsi le risque de détérioration des éléments sensibles est écarté. De plus, le procédé peut être mis en oeuvre automatiquement et rapidement même lorsque la puce testée présente un nombre d'électrodes important.

Selon un aspect particulier de l'invention on peut tester les éléments sensibles, par exemple des électrodes, soit de façon collective soit successivement et individuellement.

A titre d'exemple, on peut effectuer des tests successifs portant sur un ensemble d'éléments sensibles adressés auquel on ajoute respectivement un élément sensible supplémentaire à chaque test.

On peut également effectuer un test portant simultanément sur une pluralité d'éléments sensibles de la puce ou sur tous les éléments sensibles de la puce.

Selon une mise en oeuvre particulière du procédé, le signal électrique de test peut simplement être un potentiel électrique. On entend par potentiel électrique une différence de potentiel mesurée par exemple par rapport à la contre-électrode.

Lorsqu'un potentiel électrique est appliqué à une électrode ou à un élément sensible (conducteur), un courant électrique est engendré à travers la solution conductrice jusqu'à la contre-électrode. Ce courant mesuré constitue alors un signal de sortie. De la même façon, lorsqu'un potentiel est appliqué à plusieurs électrodes, le signal de sortie comprend la somme des courants engendrés dans la solution conductrice à partir de chaque électrode adressée.

Eventuellement, le potentiel électrique appliqué aux électrodes peut être réglé par rapport à une électrode de référence également en contact avec la solution conductrice.

L'invention a aussi pour objet un dispositif de test d'éléments sensibles adressables, tels que des électrodes d'une puce électronique. Le dispositif comporte :
- une cellule électrochimique contenant une solution conductrice, apte à recevoir les éléments sensibles adressables de la puce électronique,
- des moyens pour adresser sélectivement au moins un élément sensible et pour y appliquer au moins un signal, dit signal d'entrée,
- des moyens, reliés à au moins une électrode en contact avec la solution conductrice, pour mesurer au moins un signal, dit signal de sortie, en réponse au signal d'entrée appliqué à au moins un élément sensible de la puce électronique.

Dans le cas où la puce comporte une pluralité d'électrodes, une ou plusieurs de ces électrodes peu(ven)t être utilisée(s) pour mesurer le signal de sortie. Une électrode particulière, indépendante de la puce, peut aussi être mise en contact avec la solution conductrice pour mesurer le signal de sortie. Dans la suite du texte, l'électrode utilisée pour fermer le circuit est désignée par contre-électrode.

La cellule électrochimique peut être formée par tout dispositif permettant de mettre en contact les éléments sensibles de la puce et la contre-électrode avec une solution conductrice.

Selon une réalisation particulière, la cellule électrochimique peut comporter une cuve contenant la solution conductrice.

La contre-électrode peut être séparée de la puce et plongée dans la solution conductrice. Elle peut également être formée directement sur la puce et être mise en contact avec la solution conductrice en même temps que les électrodes de la puce.

Les moyens pour adresser sélectivement les éléments sensibles et y appliquer un signal d'entrée peuvent comporter une alimentation, capable de délivrer un potentiel, et un système d'adressage des électrodes pour appliquer ledit potentiel à une ou plusieurs électrodes sélectionnées.

D'autres caractéristiques et avantages de la présente invention ressortiront mieux de la description qui va suivre, en référence aux figures des dessins annexés. Cette description est donnée à titre purement illustratif et non limitatif.

En particulier, la description qui suit se réfère explicitement au cas particulier dans lequel les éléments sensibles de la puce sont des électrodes d'analyse de produits chimiques ou biologiques.

Pour mesurer le signal de sortie, le dispositif peut comporter un système de mesure d'un courant généré dans la cellule électrochimique et qui traverse la contre-électrode, en fonction d'un nombre d'éléments sensibles adressés.

L'invention ne se limite cependant pas à cette application. En effet, d'autres éléments sensibles plus complexes tels que des microsystèmes mécaniques, des accélérateurs ou plus généralement des éléments comportant au moins une armature conductrice adressable peuvent être testés comme les électrodes conductrices simples.

### Brève description des figures

- La figure 1A, déjà décrite, est une coupe schématique d'une puce électronique comportant des électrodes conductrices adressables.
- La figure 1B, déjà décrite, est une coupe schématique de la puce électronique de la figure 1A après une opération de garnissage des électrodes.
- La figure 2 est une représentation schématique d'un dispositif de test conforme à l'invention.
- La figure 3 est un graphique représentant l'allure d'un signal de sortie fourni par le dispositif à la figure 2 lors d'un test d'une puce fonctionnant correctement.
- Les figures 4, 5 et 6 sont des graphiques représentant l'allure d'un signal de sortie du dispositif de la figure 2 lors de tests de puces partiellement ou totalement défectueuses.
- La figure 7 est un graphique représentant l'allure du signal de sortie obtenu lors d'un test non cumulatif sur une puce comportant 128 électrodes.

### Description détaillée de modes de mise en oeuvre de l'invention

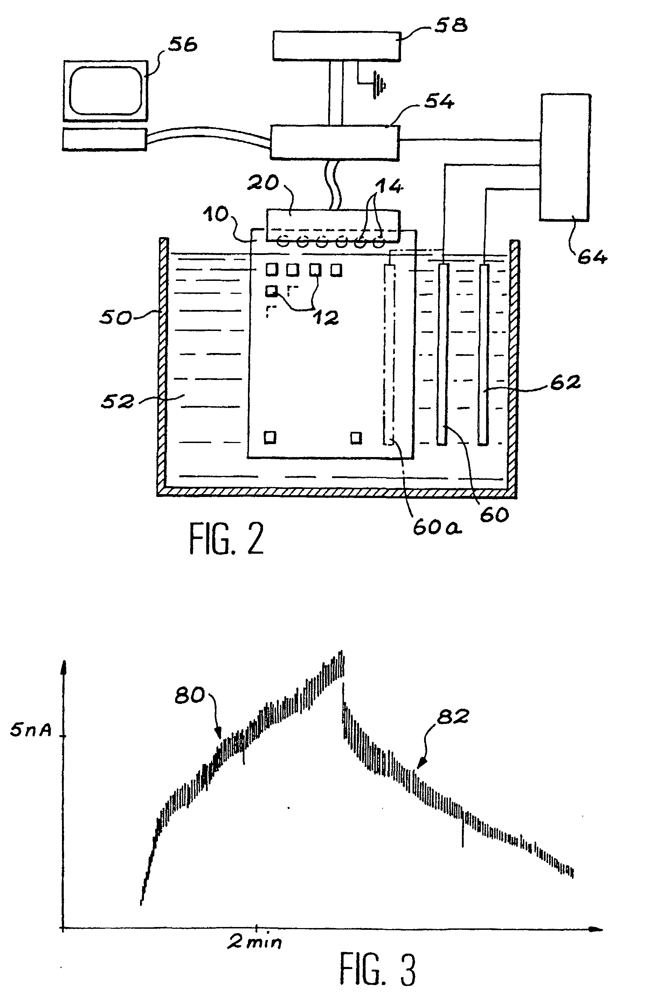

La figure 2 montre un dispositif de test conforme à l'invention.

Le dispositif comporte une cuve 50 contenant une solution conductrice 52. Dans l'exemple particulier décrit, la solution conductrice est une solution décimolaire de LiClO₄. La solution conductrice peut être choisie, par exemple, en fonction des puces à tester et notamment en fonction du milieu biologique ou chimique dans lequel les puces doivent ultérieurement être utilisées.

Pour des puces particulièrement fragiles, la solution conductrice peut être de l'eau avec un pH sensiblement neutre, rendue conductrice par l'ajout d'un sel par exemple.

Une puce 10, comportant des électrodes 12, est introduite dans la cuve de façon que la solution conductrice recouvre la partie de la puce comportant les électrodes.

Les bornes d'entrée-sortie 14 de la puce sont reliées à un module d'adressage 54 par l'intermédiaire d'un connecteur 20.

Le module d'adressage 54, piloté par un micro-ordinateur 56 permet, par l'application d'un signal de sélection sur les bornes d'entrée-sortie de sélectionner sur la puce une ou plusieurs électrodes pour les mettre en liaison électrique avec un générateur d'un signal d'entrée.

Dans l'exemple décrit, le générateur de signal d'entrée est simplement une source de tension constante 64 capable d'appliquer un potentiel, par exemple 0,6 volts, sur les électrodes sélectionnées.

Le potentiel appliqué aux électrodes sélectionnées peut être compris, par exemple, comme une différence de potentiel entre les électrodes et une contre-électrode 60 plongée également dans la solution conductrice 52.

La contre-électrode 60 peut être un fil de platine.

Selon une variante, représentée en trait mixte, la contre-électrode peut également être une plage métallique 60a formée directement sur la puce 10.

Le potentiel du signal d'entrée peut aussi être ajusté par rapport à une électrode de référence 62, par exemple une électrode au calomel saturé, qui est également en contact avec la solution conductrice.

Un signal de sortie du dispositif de test reflète, par exemple, un courant électrique traversant la solution conductrice. Ce courant est mesuré sur la contre-électrode.

Des moyens de mesure 64, comprenant par exemple un potentiostat, sont connectés à la contre-électrode, éventuellement à l'électrode de référence et au module d'adressage, afin de tenir compte de la tension appliquée aux électrodes. Ces moyens permettent d'enregistrer ainsi le courant de la contre-électrode en fonction des électrodes adressées. Le courant de la contre-électrode peut être enregistré, par exemple, par une table traçante.

Pour tester une puce, il est possible, par exemple, d'adresser successivement et individuellement les électrodes les unes après les autres en appliquant à chaque électrode adressée la tension délivrée par la source de tension.

Dans ce cas, pour chaque électrode on mesure le courant électrique engendré et on vérifie si ce courant se situe dans une fourchette prédéterminée. Lorsque le courant mesuré est inférieur aux valeurs de la fourchette on peut considérer, par exemple, que la surface de l'électrode n'est pas homogène ou qu'elle est partiellement ou totalement recouverte par un résidu. Un courant supérieur aux valeurs de la fourchette peut traduire une mise à nu du matériau sous-jacent de l'électrode située sous la couche de revêtement.

Le test de la puce peut également être un test dit cumulatif. Le potentiel de la source de tension est d'abord appliqué dans une première étape à une seule électrode adressée. A chaque étape suivante une électrode supplémentaire est adressée pour finir par appliquer le potentiel de tension à toutes les électrodes.

A chaque étape le courant électrique traversant la contre-électrode est mesuré. Ce courant correspond à la somme des courants engendrés depuis chacune des électrodes.

Les figures 3 à 6 montrent des enregistrements du signal de sortie mesuré dans un test de type cumulatif pour différentes puces électroniques. Ces figures sont des graphiques indiquant en ordonnée le courant total traversant la contre-électrode, et en abscisse une durée en temps. Pour des raisons de clarté, le graphique de la figure 3 présente une échelle de temps volontairement dilatée.

Les enregistrements des figures 3 à 6 correspondent au test de puces comprenant une matrice de 128 électrodes adressées successivement et cumulativement au cours du temps, chacune avec un potentiel de 0,6 volt.

Sur la figure 3, on distingue deux phases. Lors d'une première phase 80, un nombre toujours croissant d'électrodes est adressé jusqu'à ce que les 128 électrodes soient portées au potentiel de test. Dans cette phase, le courant mesuré augmente pour chaque nouvelle électrode adressée.

Lors d'une deuxième phase 82 des électrodes sont successivement retirées du groupe des électrodes adressées. Le courant de sortie mesuré diminue pour chaque électrode retirée.

La figure 3 illustre un cas favorable ou toutes les électrodes sont fonctionnelles et où la puce est donc valide. En effet, le graphe montre un incrément (respectivement un décrément) régulier du courant lors de chaque étape de connexion (déconnexion) d'une électrode supplémentaire au potentiel de test. De plus, le courant total reste faible, de l'ordre de 6 nA.

On en conclut non seulement que l'adressage des électrodes est correct, ce qui traduit un bon fonctionnement du circuit de multiplexage, mais aussi que le revêtement de garniture des électrodes est homogène et sans défaut.

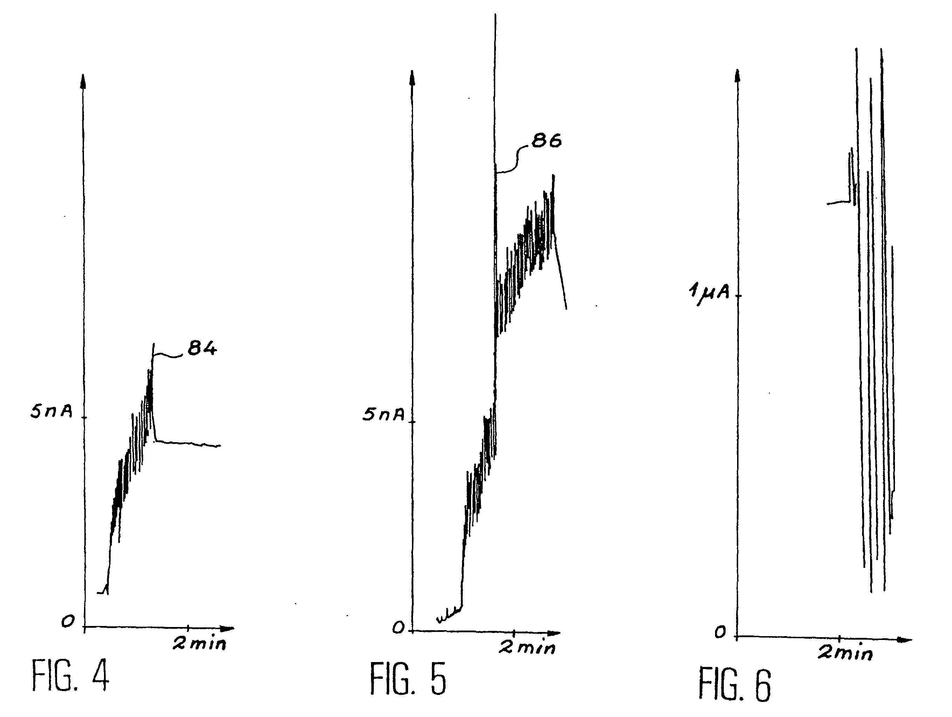

Le graphique de la figure 4 est obtenu avec une puce partiellement recouverte par un dépôt. Le test se déroule normalement jusqu'à la 64ème électrode (parmi 128), repérée avec la référence 84. A partir de là le courant du signal de sortie mesuré se stabilise et plus aucun courant additionnel n'est visible.

La puce testée utilisée pour établir ce graphique est recouverte sur la moitié de sa surface par une couche de vernis utilisé pour le conditionnement de la puce.

Seuls 50% des électrodes de la puce sont utilisables.

Le graphique de la figure 5 est obtenu avec une puce présentant quelques électrodes défectueuses.

L'adressage et le test se déroulent normalement jusqu'à la 51ème électrode. Les incréments de courant sont en effet réguliers et le courant total est inférieur à 5nA.

Un pic de courant 86 coïncide avec l'adressage des 51ème et 52ème électrodes. Pour ces électrodes défectueuses, le courant de sortie est supérieur à 100 nA.

Le pic de courant 86 du signal de sortie traduit une destruction mécanique de la surface (en or) des électrodes concernées.

Après une déconnexion de ces électrodes le signal de sortie reprend une allure normale.

Le graphique de la figure 6 est obtenu avec une puce présentant un défaut d'ordre électrochimique.

On observe que le signal de sortie correspond à des courants très importants, de l'ordre du µA ou plus, comparativement aux courants des courbes précédentes. Il est impossible de suivre l'adressage sur le graphique.

La puce utilisée pour effectuer cette expérience a été testée préalablement par des techniques traditionnelles pour assurer le bon fonctionnement de son système d'adressage.

Ainsi, les courants élevés mesurés traduisent une incompatibilité du revêtement des électrodes avec la solution conductrice utilisée.

Les couches (d'or) recouvrant les électrodes ne sont pas "étanches" et des réactions d'oxydation réduction des matériaux sous-jacents conduisent à une destruction de la puce.

Lorsque les tests sont achevés et qu'un fonctionnement correct de la puce est constaté, la puce est extraite de la solution conductrice, rincée à l'eau distillée, puis séchée.

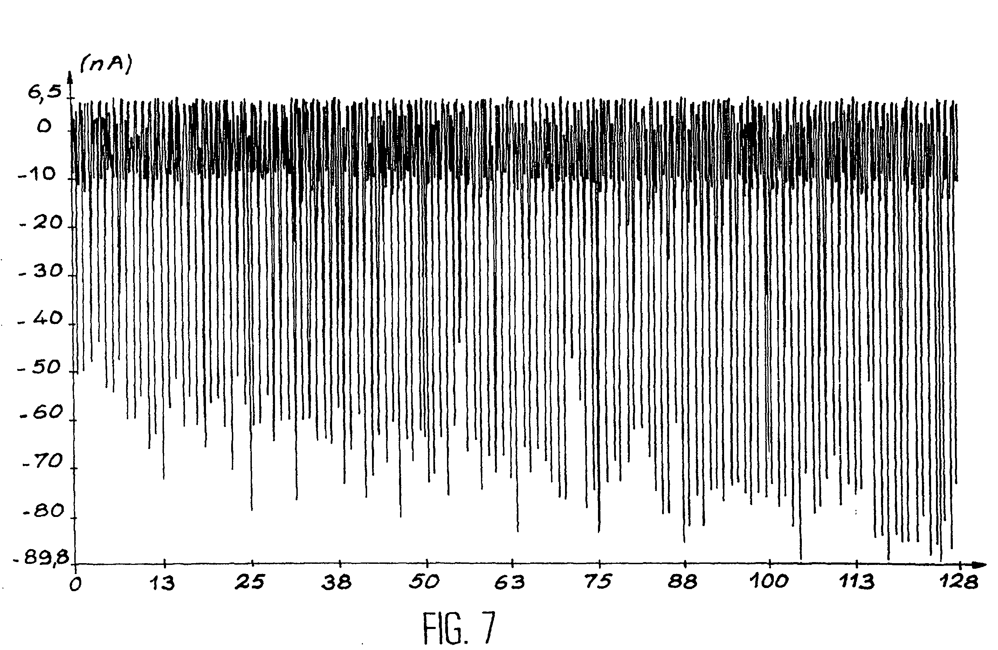

La figure 7 est un enregistrement effectué dans les mêmes conditions de test que celles décrites précédemment. Toutefois, le test, effectué sur une puce portant 128 électrodes est un test non cumulatif.

Le graphique indique en abscisse des numéros d'ordre des électrodes successivement adressées, et en ordonnée le courant correspondant traversant la solution conductrice. Le courant est exprimé en nA et on considère, dans l'exemple décrit, qu'une valeur du courant comprise entre -10 et -100 nA correspond à une électrode utilisable.

### DOCUMENTS CITES

***(1)***
   Biofutur n° 166, Avril 1997, cahier n° 91 par Jérôme Hinfray.
***(2)***
   WO-A-94 22889 (13 Octobre 1994)
***(3)***
   "Silicon micromachining - Sensors to Systems" de G.T.A. Kovacs et coll.
   Analytical Chemistry News & Features, July 1, 1996, pages 407-412.

## Revendications

1. Procédé de test d'une puce électronique (10) comportant en surface une pluralité d'éléments sensibles (12), conducteurs et électriquement adressables, dans lequel on met en contact avec une solution conductrice (52) les éléments sensibles de la puce, on adresse sélectivement au moins un élément sensible (12) pour appliquer à chaque élément sensible adressé un signal électrique de test, dit signal d'entrée, et on mesure un signal, dit signal de sortie, sur au moins une électrode (60, 60a) également en contact avec la solution conductrice.

2. Procédé selon la revendication 1, dans lequel les éléments sensibles (12) sont des électrodes.

3. Procédé de test selon la revendication 1, dans lequel on teste successivement et individuellement chaque élément sensible (12) de la puce (10).

4. Procédé de test selon la revendication 1, dans lequel on effectue des tests successifs d'un ensemble d'éléments sensibles (12) adressés, un élément sensible supplémentaire étant adressé à chaque test.

5. Procédé de test selon la revendication 1, dans lequel on effectue un test simultané d'une pluralité d'éléments sensibles.

6. Procédé selon la revendication 1, dans lequel le signal électrique de test est un potentiel électrique.

7. Procédé selon la revendication 6, dans lequel le potentiel électrique est réglé par rapport à une électrode de référence (62) en contact avec la solution conductrice.

8. Dispositif de test d'une puce électronique avec une pluralité d'éléments sensibles adressables, comportant :
- une cellule électrochimique (50), contenant une solution conductrice (52), apte à recevoir les éléments sensibles adressables (12) de la puce électronique (10),
- des moyens (54, 56, 58) pour adresser sélectivement au moins un élément sensible et pour y appliquer au moins un signal dit signal d'entrée,
- des moyens (64), reliés à au moins une électrode (60, 60a) en contact avec la solution conductrice, appelée contre-électrode, pour mesurer au moins un signal dit signal de sortie en réponse au signal d'entrée.

9. Dispositif selon la revendication 8, dans lequel les éléments sensibles (12) sont des électrodes.

10. Dispositif selon la revendication 8, dans lequel la contre-électrode (60) est un fil de platine.

11. Dispositif selon la revendication 8, dans lequel la contre-électrode (60a) est ménagée sur la puce électronique.

12. Dispositif selon la revendication 8, dans lequel les moyens pour adresser sélectivement les éléments sensibles (12) et y appliquer un signal d'entrée comportent une alimentation (58) capable de délivrer une tension et un système (54) d'adressage des éléments sensibles pour appliquer ladite tension à un ou plusieurs éléments sensibles sélectionnés.

13. Dispositif selon la revendication 8, dans lequel les moyens (64) pour mesurer le signal de sortie comportent un système de mesure d'un courant généré dans la cellule électrochimique, et traversant la contre-électrode, en fonction d'un nombre d'éléments sensibles adressés.

## Patentansprüche

1. Verfahren zur Prüfung eines elektronischen Chips (10), der an seiner Oberfläche eine Vielzahl sensibler, leitfähiger und elektronisch adressierbarer Elemente (12) umfasst, bei dem man die sensiblen Elemente des Chips mittels einer leitenden Lösung (52) in Kontakt miteinander bringt, selektiv wenigstens ein sensibles Element (12) adressiert, um in jedes adressierte sensible Element ein elektrisches Prüfungssignal einzuspeisen, Eingangssignal genannt, und man ein Ausgangssignal genanntes Signal an wenigstens einer Elektrode (60, 60a) misst, die ebenfalls mit der leitenden Lösung in Kontakt ist.

2. Verfahren nach Anspruch 1, bei dem die sensiblen Elemente (12) Elektroden sind.

3. Verfahren nach Anspruch 1, bei dem man jedes sensible Element (12) des Chips (10) nacheinander und einzeln misst.

4. Verfahren nach Anspruch 1, bei dem man aufeinanderfolgende Prüfungen einer Gruppe adressierter sensibler Elemente (12) durchführt, wobei bei jeder Prüfung ein zusätzliches sensibles Element adressiert wird.

5. Verfahren nach Anspruch 1, bei dem man eine gleichzeitige Prüfung einer Vielzahl sensibler Elemente durchführt.

6. Verfahren nach Anspruch 1, bei dem das elektrische Prüfungssignal ein elektrisches Potential ist.

7. Verfahren nach Anspruch 6, bei dem das elektrische Potential in Bezug auf eine Referenzelektrode (62) geregelt wird, die in Kontakt mit der leitenden Lösung ist.

8. Vorrichtung zur Prüfung eines elektronischen Chips mit einer Vielzahl adressierbarer sensibler Elemente, umfassend:
- eine elektrochemische Zelle (50), die eine leitende Lösung (52) zur Aufnahme der adressierbaren sensiblen Elemente (12) des elektronischen Chips (10) enthält,
- Einrichtungen (54, 56, 58), um wenigstens ein sensibles Element zu adressieren und in dieses Element ein Eingangssignal genanntes Signal einzuspeisen,
- Einrichtungen (64), verbunden mit wenigstens einer Elektrode (60, 60a), in Kontakt mit der leitenden Lösung und Gegenelektrode genannt, um wenigstens ein Ausgangssignal genanntes Signal als Antwort bzw. Reaktion auf das Eingangssignal zu messen.

9. Vorrichtung nach Anspruch 8, bei der die sensiblen Elemente (12) Elektroden sind.

10. Vorrichtung nach Anspruch 8, bei der die Gegenelektrode (60) ein Platindraht ist.

11. Vorrichtung nach Anspruch 8, bei der die Gegenelektrode (60a) auf dem elektronischen Chip vorgesehen ist.

12. Vorrichtung nach Anspruch 8, bei der die Einrichtungen, die dazu dienen, die sensiblen Elemente (12) zu adressieren und in sie ein Eingangssignal einzuspeisen, eine Versorgung (58), fähig eine Spannung zu liefem, und ein System (54) zum Adressieren der sensiblen Elemente umfassen, um die genannte Spannung an ein oder mehrere selektierte Elemente anzulegen.

13. Vorrichtung nach Anspruch 8, bei der die Einrichtungen (64) zum Messen des Ausgangssignals ein System zum Messen eines Stroms umfassen, der in der elektrochemischen Zelle erzeugt wird und die Gegenelektrode in Abhängigkeit von einer Anzahl adressierter sensibler Elemente durchquert.

## Claims

1. A method of testing an electronic chip (10) having on the surface a plurality of conductive and electrically addressable sensitive elements (12), in which the sensitive elements on the chip are put in contact with a conductive solution (52), at least one sensitive element (12) is selectively addressed in order to apply to each sensitive element addressed an electrical test signal, referred to as the input signal, and a signal referred to as the output signal, on at least one electrode (60, 60a) also in contact with the conductive solution, is measured.

2. A method according to Claim 1, in which the sensitive elements (12) are electrodes.

3. A test method according to Claim 1, in which each sensitive element (12) on the chip (10) is tested successively and individually.

4. A test method according to Claim 1, in which successive tests are carried out on a set of sensitive elements (12) addressed, an additional sensitive element being addressed at each test.

5. A test method according to Claim 1, in which a simultaneous test is carried out on a plurality of sensitive elements.

6. A method according to Claim 1, in which the electrical test signal is an electrical potential.

7. A method according to Claim 6, in which the electrical potential is adjusted with respect to a reference electrode (62) in contact with the conductive solution.

8. A device for testing an electronic chip with a plurality of addressable sensitive elements, having:
- an electrochemical cell (50), containing a conductive solution (52), able to receive the addressable sensitive elements (12) on the electronic chip (10),
- means (54, 56, 58) for selectively addressing at least one sensitive element and for applying thereto at least one signal, referred to as an input signal,
- means (64), connected to at least one electrode (60, 60a) in contact with the conductive solution, referred to as the counter-electrode, for measuring at least one signal, referred to as an output signal, in response to the input signal.

9. A device according to Claim 8, in which the sensitive elements (12) are electrodes.

10. A device according to Claim 8, in which the counter-electrode (60) is a platinum wire.

11. A device according to Claim 8, in which the counter-electrode (60a) is provided on the electronic chip.

12. A device according to Claim 8, in which the means for selectively addressing the sensitive elements (12) and applying thereto an input signal include a power supply (58) capable of delivering a voltage and a system (54) for addressing the sensitive elements in order to apply the said voltage to one or more selected sensitive elements.

13. A device according to Claim 8, in which the means (64) for measuring the output signal include a system for measuring a current generated in the electrochemical cell, and passing through the counter-electrode, according to the number of sensitive elements addressed.
